# EUROPEAN PATENT APPLICATION

(11) **EP 2 645 117 A1**
(43) Date of publication of application: **02.10.2013**
(21) Application number: 12305372.0
(22) Date of filing: 30.03.2012
(51) Int. Cl.: G01R 31/36, G01R 19/165, H01M 10/48

(54) **Battery monitor with alarm activated by voltage or temperature threshold**

(71) Applicant: EH Europe GmbH, 8001 Zürich (CH)
(72) Inventor: Kechmire, Mohamed, 62033 Arras (FR); Beaucamp, François, 62033 Arras (FR)
(74) Representative: Williams, Rhys Nicholas

(57) **Abstract**

The invention provides a battery monitoring device and method for monitoring a battery. The battery monitoring device comprises a voltage sensor and an alarm. The voltage sensor is arranged to monitor the voltage of the battery and the alarm is arranged to be activated if the voltage sensor detects a voltage below a threshold level. The battery monitoring device may be configured to operate in a first mode or a second, the first mode of operation being when the battery is in a storage state, and the second mode of operation being when the battery is in a discharging state.

## Description

### Field of the Invention

The present invention concerns an apparatus and method for monitoring a battery. More particularly, but not exclusively, this invention concerns an apparatus and method for monitoring at least the voltage and/temperature of a battery.

### Background of the Invention

Large industrial users of batteries typically have a large number of batteries that are used to power, for example, a fleet of fork lift trucks. The batteries may be cycled into and out of use for charging or other purposes. Therefore, at any time, there may be one of more batteries that are not being used by the industrial user. The batteries not being used may typically be stored in a battery store room within a warehouse, or otherwise located in storage areas of a warehouse. It may be necessary for the warehouse foreman to monitor the use and storage of these batteries in order to prevent damage that may be caused by any of the effects described below.

There are various ways in which the performance and lifetime of a battery may be adversely affected.

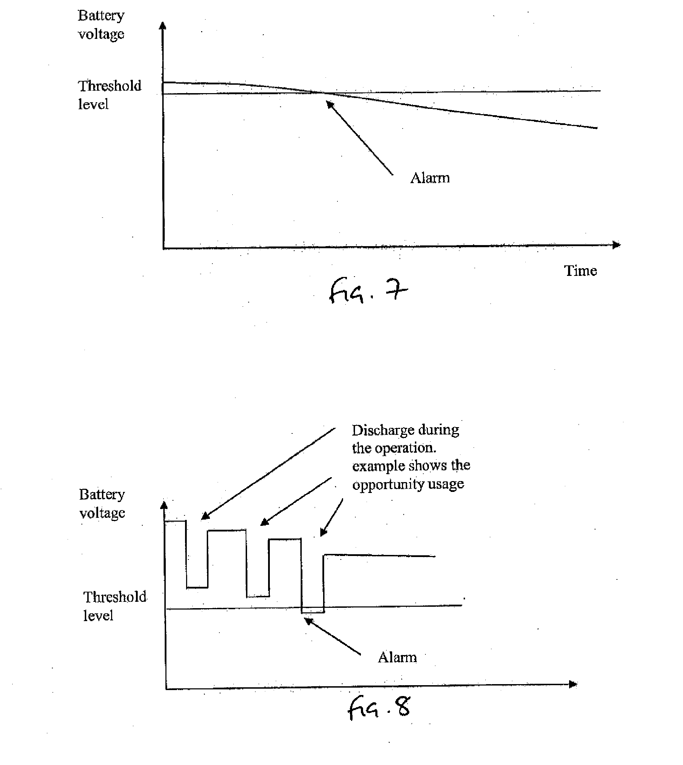

During battery storage, battery voltage will decrease due to the internal resistance of the battery. Also during extended storage, the specific gravity of battery electrolyte may progressively decrease and the electromotive force of the battery may also decrease. If the battery is left for a long enough period of time, this gradual decrease in voltage may also take the battery voltage to a threshold level, below which the battery is permanently damaged. Figure 7 shows an example of a battery voltage dropping as described during storage.

When a battery is being used, repeated discharge may result in an over-discharge taking the battery voltage below a threshold level, under which the battery will not be able to be fully recharged. Figure 8 shows an possible use profile where a battery is discharged as described.

Additionally, the temperature at which a battery is stored may reduce the lifetime performance of the battery, typically with high temperatures reducing the performance of the battery.

The present invention seeks to mitigate the above-mentioned problems.

### Summary of the Invention

According to a first aspect of the invention, there is provided a battery comprising a battery monitoring device; wherein the battery monitoring device comprises:
a voltage sensor arranged to monitor the voltage of the battery; and
an alarm;
wherein the alarm is arranged to be activated if the voltage sensor detects a voltage below a threshold level.
Should the voltage of the battery drop below the threshold level, which may be set to be above the level at which the battery suffers permanent damage, the alarm is activated and appropriate remedial action may be taken, for example, resting the battery if the damage would be caused by an over discharge during use, or charging the battery if the damage would be caused by a gradual voltage drop during storage.

The battery monitoring device may further comprise a temperature sensor arranged to monitor the temperature of the battery. The alarm may be arranged to be activated if the temperature sensor detects a battery temperature above or below a threshold value. Such an arrangement may prevent the battery being damaged by high or low temperatures as the alarm being activated may result in appropriate remedial action being taken.

The battery monitor device may comprise a control unit, the control unit programmable such that the control unit commands the voltage sensor to monitor the voltage of the battery. The control unit may be programmable for setting the threshold level under which an alarm is activated. The control unit may be programmable such that the control unit commands the alarm to activate should the voltage sensor detect a voltage below the threshold level.

The battery monitor device may be arranged to operate in a first mode and a second mode. The battery monitor device may operate in the first mode when the voltage sensor detects that the battery is in a storage state. The battery monitor device may operate in the second mode when the voltage sensor detects that the battery is in a discharge/charging state. Determination between the storage state and discharge/charging state may be made by measuring the rate of change of the battery voltage over time. If the rate of change is below a predetermined level, the battery monitor may operate in the first mode. If the rate of change is above a predetermined level, the battery monitor may operate in the second mode.

In the first mode of operation the alarm may be arranged to be activated if the voltage drops below a first threshold level. In the second mode of operation the alarm may be arranged to be activated if the voltage drops below a second threshold level. The first threshold level and second threshold level may be different. If the threshold level for permanent battery damage is different depending on whether the battery is being discharged or being stored, such an arrangement allows the battery monitoring device to be tailored accordingly.

The alarm may be a visual alarm. The alarm may be one or more lights. The alarm may be an audible alarm. The alarm may be a combination of one or more audible or visual elements that are configured such that different combinations of elements indicate different types of alarm. For example, the alarm being activated in the first mode of operation may look and/sound different to the alarm being activated in the second mode of operation. The alarm may indicate that appropriate remedial action is required even if the battery supervisor or factory foreman is not in close proximity to the battery, or does not have a line of sight to the battery.

The battery monitoring device may have a recording unit. The recording unit may be arranged to record the monitored battery parameters. The recording unit may be arranged to provide recorded information to external devices, such as laptops or PDAs. This may demonstrate that a battery has not been stored and/or used according to prescribed conditions. This may be beneficial for the battery manufacturer with regards to, for example, warranty claims, or when monitoring long-term battery performance.

The battery monitoring device may comprise a second voltage sensor, the second voltage sensor arranged to monitor the balance voltage of the battery. Monitoring the balance voltage of the battery may provide an indication that the battery has suffered cell damage. The alarm may be configured to be activated if the second voltage sensor detects an unbalanced voltage.

The battery and battery monitoring device may be permanently adjoined, for example by sharing a moulded shell. Alternatively, the battery monitoring device may be removable from the battery. The battery monitoring device may be retrofitted to a battery.

According to a second aspect of the invention, there is provided a battery monitoring device, the battery monitoring device comprising a voltage sensor arranged to monitor the voltage of a battery; and
an alarm;
wherein the alarm is arranged to be activated if the voltage sensor detects a voltage below a threshold level. The battery monitoring device may include any or all of the features as described above.

According to a third aspect of the invention there is also provided a method of monitoring the voltage of a battery comprising the steps of:
providing a battery including a battery monitoring device, wherein the battery monitoring device comprises a voltage sensor arranged to detect the voltage of the battery and an alarm;
the battery monitoring device operating in a first mode of operation if the voltage sensor detects that the rate of change of battery voltage is below a preset level;
the voltage sensor monitoring the voltage of the battery; and
activating the alarm if the voltage sensor detects the battery voltage has dropped below a first threshold level.

The first mode of operation may correspond to the battery being in a storage state. The method may prevent the gradual dropping of voltage during storage dropping to a level where the battery is permanently damaged.

The method may include the additional step of:
the battery monitoring device operating in a second mode of operation if the voltage sensor detects that the rate of change of battery voltage is above a preset level; the voltage sensor monitoring the voltage of the battery; and activating the alarm if the voltage sensor detects the battery voltage has dropped below a second threshold level.

The second mode of operation may correspond to the battery being in a discharge state. The method may prevent the over discharge of the battery during use which can cause permanent damage to the battery.

The battery monitoring device may comprise a temperature sensor arranged to monitor the temperature of the battery. The method may include the step of activating the alarm if the temperature of the battery is detected to be above or below a preset value.

The activation of the alarm may alert a battery user, supervisor, or warehouse foreman, that appropriate remedial action must be taken. This may be to rest the battery, charge the battery, or cool or heat the battery.

It will of course be appreciated that features described in relation to one aspect of the present invention may be incorporated into other aspects of the present invention. For example, the method of the invention may incorporate any of the features described with reference to the apparatus of the invention and *vice versa.*

### Description of the Drawings

Embodiments of the present invention will now be described by way of example only with reference to the accompanying schematic drawings of which:
- Figure 1: shows a schematic view of a battery and battery monitoring device according to a first embodiment of the invention;
- Figure 2: shows a schematic view of a circuit illustrative of a possible layout of a battery monitoring device according to the invention; and
- Figure 3: shows a flow chart of a potential initialisation method of a battery monitoring device according to the invention;
- Figure 4: shows a flow charge of the battery cell determination undertaken by a battery monitoring device according to the invention;
- Figure 5: shows the main program of a battery monitoring device according to the invention; and
- Figure 6: shows the balance voltage detection method of a battery monitoring device according to the invention;
- Figure 7: shows a graph of how the battery voltage may drop below a first threshold level during storage; and
- Figure 8: shows a graph of how the battery voltage may drop below a second threshold level during a discharge operation.

### Detailed Description

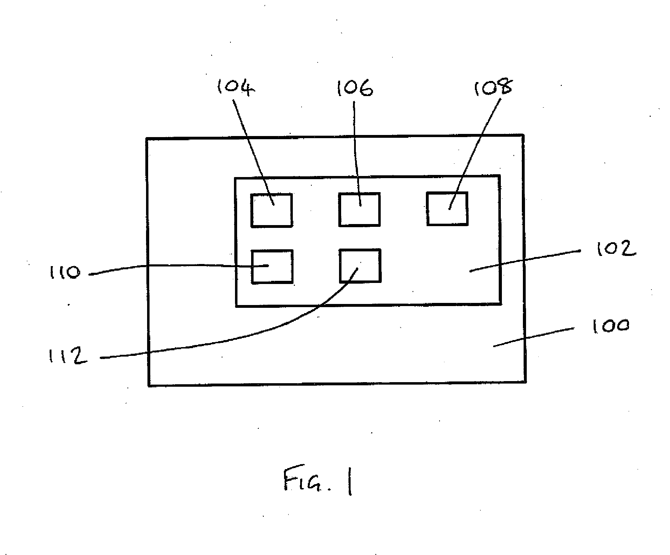

Figure 1 shows a schematic representation of a battery 100 and a battery monitoring device 102. The battery monitoring device comprises a voltage sensor 104 arranged to detect the voltage of the battery, a temperature sensor 106 arranged to detect the temperature of the battery, and an alarm 108 arranged to be activated in dependence the input from the voltage sensor 104 and temperature sensor 106. The battery monitoring device 102 also includes an external serial link 110 arranged to be connectable to an external PDA or laptop. The battery monitoring device 102 also includes a balance voltage sensor 112 arranged to monitor the balance voltage of the battery 100.

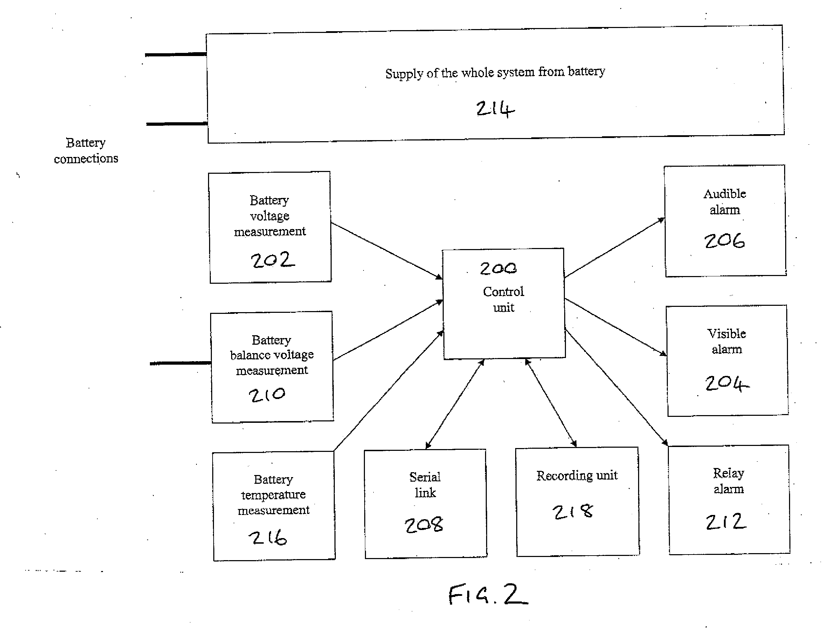

Figure 2 shows a circuit diagram illustrating a potential arrangement for the battery monitoring device as shown in figure 1. A control unit 200 and temperature sensor 216 is shown, a voltage sensor 202, a visible alarm 204, and an audible alarm 206, an external serial link 208, a balance voltage sensor 210, a relay 212, the supply from the battery 214, and a recording unit 218.

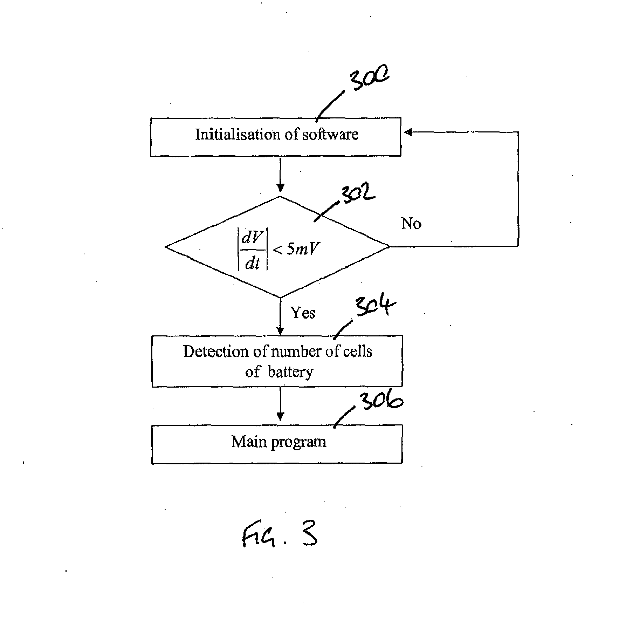

Figure 3 shows an example algorithm the battery monitoring device may go through when first connected to a battery and activated. It is well known in the art that batteries are made up of a number of individual battery cells, and the number of cells used, typically 2V cells, determine the voltage of the battery. One aspect of the invention may be to provide a battery monitoring device that can be applied to any battery without prior determination of the number of cells in the battery. In this case, the battery monitoring device, when initialised 300, first checks if the rate of change of voltage with time (dV/dt) is less than 5mV/s 302. This indicates that the battery is being stored. If not, the program loops back to the initialisation stage until the battery is being stored. If dV/dt is less than 5mV/s, the program then goes on to detect the number of cells in the battery 304, and then onto the main program 306.

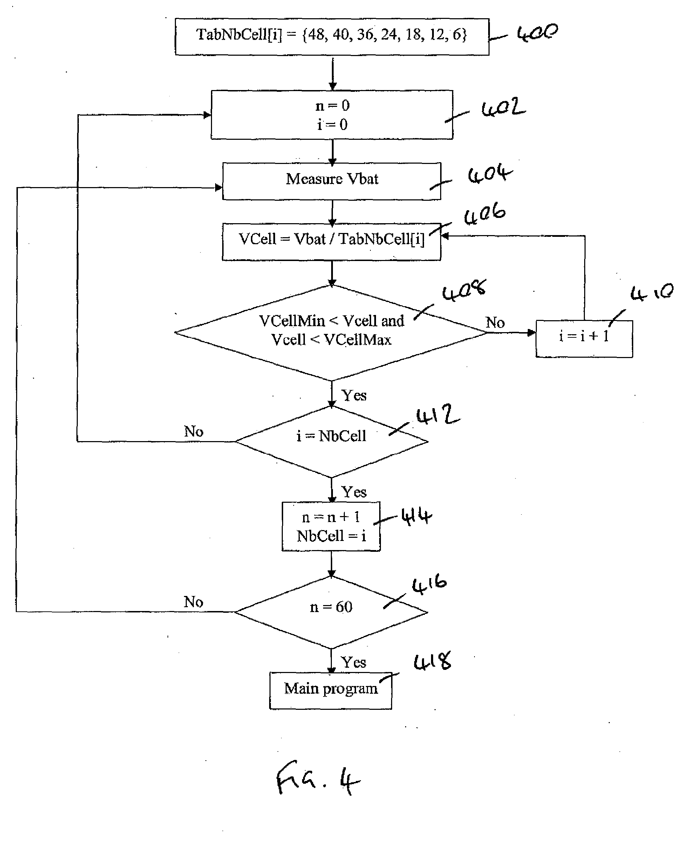

Figure 4 shows the algorithm for detecting the number of cells in more detail. The battery monitoring device includes a table including the various different numbers of cells a battery may contain 400. n represents the number of loops the battery monitoring device has run through, and i represents the proposed number of battery cells 402. The battery monitoring device then measures the voltage of the battery (Vbat) 404. The voltage of each cell (Vcell) is calculated by dividing Vbat by the proposed number of cells 406. The value is compared to the maximum and minimum values that Vcell may take 408. If the calculated value of VCell is not between the minimum and maximum value, the cycle is repeated with i = i + 1, as shown in 410. If VCell does lie within the correct range, then i = the number of cells in the battery 414. This step is repeated 60 times and provided the same value of i is calculated for each loop, then i is recorded as the number of cells in the battery and the battery monitoring device moves into the main program. Such an arrangement allows a universal battery monitoring device to be fitted to several types of battery without requiring that the number of cells in the battery is set prior to the battery monitoring device being fixed.

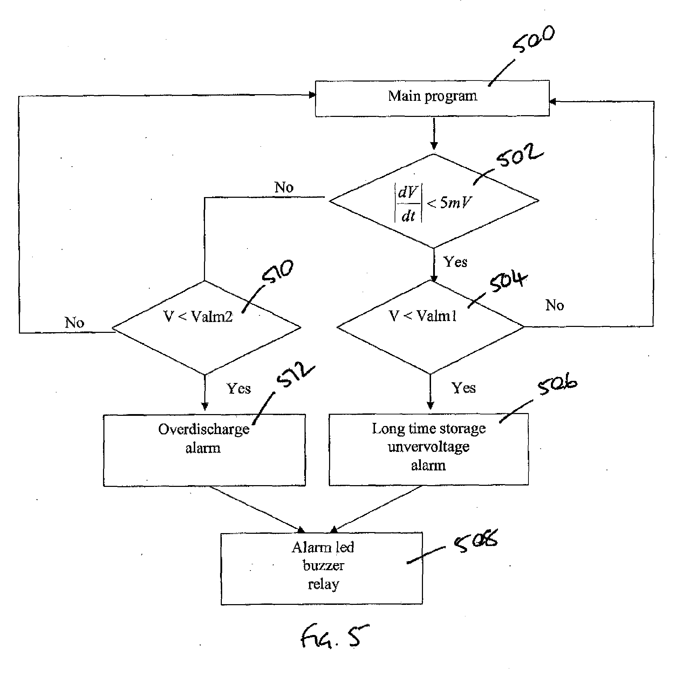

Figure 5 shows the main program that the battery monitoring device may run through following the steps as described above. The first step of the main program 500 is to determine whether the rate of change of the voltage (dV/dt) is less than 5mV/s. If yes, this indicates the battery is being stored, and the battery monitoring device proceeds in a first mode of operation. The voltage sensor detects whether the voltage of the battery is below a first threshold value (Valm1) 504. If not, the program returns to the start 500. If yes, then the storage under voltage alarm is activated 506, including the audible alarm and visual alarm 508. If dV/dt is greater than 5mV/s then this indicates that the battery is being used and the battery monitoring device proceeds in a second mode of operation. The voltage sensor detects whether the voltage of the battery is below a second threshold value (Valm2) 510. If not, the program returns to the beginning 500. If yes, the over discharge alarm is activated 512 including the audible and visual alarm 508. Typically Valm1 is greater than Valm2. This is because batteries may be able to accommodate a low voltage during a short period of time during intensive use and afterwards return to a normal level, whereas if the voltage remained at this low level for an extended period of time during storage, permanent damage may be caused.

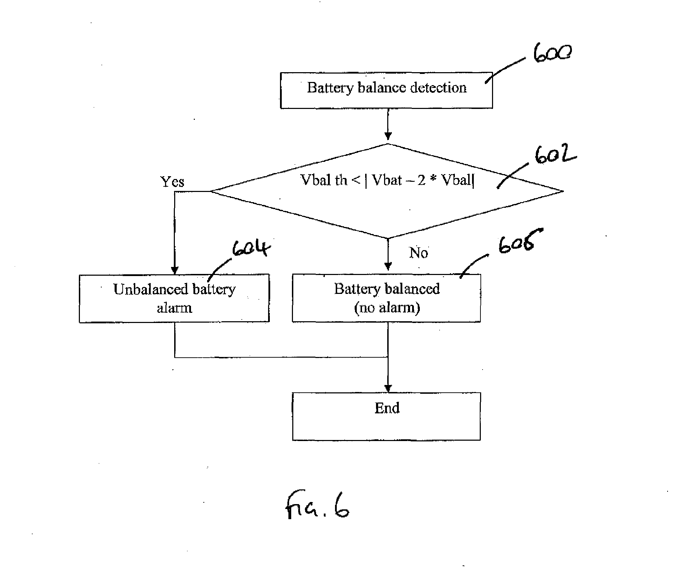

The battery monitoring device is also arranged to detect the battery balance as shown in figure 6. The balance voltage is the voltage measured at the middle of the battery. Measurement of the balance voltage provides an indication of whether any elements of the battery have failed, and which half of the battery the failed element is housed in. "Vbal th" is the authorised maximum voltage difference between the two parts of the battery. The battery balance detection program begins 600 and compares the Vbal th to the difference between the voltage of the battery (Vbat) and twice the balance voltage (Vbal) 602. If the difference is greater than the authorised difference, this indicates that the battery is unbalanced and an alarm is activated 604. If the measured difference is less than the authorised difference, this indicates that the battery is balanced and no alarm is activated 606. The battery balance detection program may run before, after, or concurrently with the main program.

As described, the battery monitoring device comprises a temperature sensor. It is known in the art that the temperature at which a battery is used or stored may adversely effected if the temperature is too high. The temperature sensor is connected to the alarm of the battery monitoring device such that the alarm is activated if a threshold temperature is exceeded.

The table below shows the various different alarm types which may be activated depending on the status of the battery being monitored. In this case, the alarm comprises a red LED, a green LED and a buzzer. The monitoring device also includes a relay which allows the battery to be connected to another device. For example, if the battery is connected to a forklift truck, the relay may switched to stop the battery driving the forklift truck.

| | Green LED | Red LED | Buzzer | Relay |
|---|---|---|---|---|
| Device Power up | Fast blink | Off | Off | Reset |
| Device initialisation | Off | Off | Off | Reset |
| Battery OK | Low frequency flash | Off | Off | Reset |
| Low voltage level 1 (Valm1) | Off | Fast Blink | Off | Reset |
| Low voltage level 2 (Valm2) | Off | On | On | Set |
| Balance Voltage off | Off | Fast Blink | On | Reset |
| Temperature too high | Off | Slow blink | Off | Reset |

The battery monitoring device is arranged such that each time an alarm occurs, the duration and type of the alarm is stored in a non-volatile memory that may be accessed by external devices via a serial link.

Whilst the present invention has been described and illustrated with reference to particular embodiments, it will be appreciated by those of ordinary skill in the art that the invention lends itself to many different variations not specifically illustrated herein.

Where in the foregoing description, integers or elements are mentioned which have known, obvious or foreseeable equivalents, then such equivalents are herein incorporated as if individually set forth. Reference should be made to the claims for determining the true scope of the present invention, which should be construed so as to encompass any such equivalents. It will also be appreciated by the reader that integers or features of the invention that are described as preferable, advantageous, convenient or the like are optional and do not limit the scope of the independent claims. Moreover, it is to be understood that such optional integers or features, whilst of possible benefit in some embodiments of the invention, may not be desirable, and may therefore be absent, in other embodiments.

## Claims

1. A battery comprising a battery monitoring device; wherein the battery monitoring device comprises:
a voltage sensor arranged to monitor the voltage of the battery; and
an alarm;
wherein the alarm is arranged to be activated if the voltage sensor detects a voltage below a threshold level.

2. A battery as claimed in claim 1, wherein the battery monitoring device further comprises a temperature sensor arranged to monitor the temperature of the battery.

3. A battery as claimed in claim 1 or claim 2, wherein the alarm is arranged to be activated if the temperature sensor detects a battery temperature above or below a threshold value.

4. A battery as claimed in any preceding claim, wherein the battery monitoring device is arranged to operate in a first mode and a second mode.

5. A battery as claimed in claim 4, wherein the battery monitoring device is arranged to operate in the first mode when the voltage sensor detects that the battery is in a storage state.

6. A battery as claimed in claim 4 or claim 5, wherein the battery monitoring device is arranged to operate in the second mode when the voltage sensor detects that the battery is in a discharging state.

7. A battery as claimed in any of claims 4 to 6, wherein when the battery monitoring device is in the first mode of operation the alarm is arranged to be activated if the voltage drops below a first threshold level.

8. A battery as claimed in any of claims 4 to 7, wherein when the battery monitoring device is in the second mode of operation the alarm is arranged to be activated if the voltage drops below a second threshold level.

9. A battery as claimed in claim 8, wherein the first threshold level and second threshold level are different.

10. A battery as claimed in any preceding claim, wherein the alarm is visual and/or audible.

11. A battery as claimed in any preceding claim, wherein the battery monitoring device comprises a recording unit.

12. A battery as claimed in any preceding claim, wherein the battery monitoring device comprises a second voltage sensor, the second voltage sensor arranged to monitor the balance voltage of the battery.

13. A battery as claimed in claim 12, wherein the alarm is configured to be activated if the second voltage sensor detects an unbalanced voltage.

14. A battery monitoring device, the battery monitoring device comprising:
a voltage sensor arranged to monitor the voltage of a battery; and
an alarm;
wherein the alarm is arranged to be activated if the voltage sensor detects a voltage below a threshold level.

15. A method of monitoring the voltage of a battery comprising the steps of:
providing a battery including a battery monitoring device, wherein the battery monitoring device comprises a voltage sensor arranged to detect the voltage of the battery and an alarm;
the battery monitoring device operating in a first mode of operation if the voltage sensor detects that the rate of change of battery voltage is below a preset level;
the voltage sensor monitoring the voltage of the battery; and
activating the alarm if the voltage sensor detects the battery voltage has dropped below a first threshold level.

16. A method as claimed in claim 15, including the additional step of:
the battery monitoring device operating in a second mode of operation if the voltage sensor detects that the rate of change of battery voltage is above a preset level; the voltage sensor monitoring the voltage of the battery; and activating the alarm if the voltage sensor detects the battery voltage has dropped below a second threshold level.

17. A method as claimed in claim 15 or 16, wherein the battery monitoring device comprises a temperature sensor arranged to monitor the temperature of the battery, and the method includes the step of activating the alarm if the temperature of the battery is detected to be above or below a preset value.
